# EUROPEAN PATENT SPECIFICATION

(11) **EP 0 359 211 B1**
(45) Date of publication and mention of the grant of the patent: **23.03.1994**
(21) Application number: 89116892.4
(22) Date of filing: 12.09.1989
(51) Int. Cl.: G11C 7/00

(54) **Semiconductor memory**
Halbleiterspeicher
Mémoire à semi-conducteurs

(30) Priority: 12.09.1988 JP 228060/88
(43) Date of publication of application: 21.03.1990
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Abe, Katsumi Intellectual Property Division, Tokyo 105 (JP); Nakagawa, Kaoru Intellectual Property Division, Tokyo 105 (JP); Koinuma, Hiroyuki Intellectual Property Division, Tokyo 105 (JP)
(74) Representative: Henkel, Feiler, Hänzel & Partner

(56) References cited:
- EP-A- 0 171 518
- EP-A- 0 224 004
- US-A- 3 691 538
- US-A- 4 697 279

## Description

The present invention relates to a semiconductor memory including a serial data output control circuit, such as an image memory.

In recent years, strong demand for achieving a high-speed operation of a semiconductor memory has arisen in various fields, and demand for a semiconductor memory capable of serial access has been increased. Such a conventional semiconductor memory, e.g., an image memory, includes a random access memory section (to be referred to as a RAM section hereinafter) capable of performing random access, and a serial access memory section (to be referred to as an SAM section hereinafter) capable of performing serial access. Data are transferred between the RAM and SAM sections through read and write latch sections, and asynchronous access of the RAM and SAM sections is performed.

The RAM section has the same arrangement as that of a conventional dynamic or static memory. An access method of the RAM section is substantially the same as in the dynamic or static memory. The SAM sections are classified into two types. One is a section for serially transferring data in practice using a shift register. The other one is a section for realizing serial access by sequentially accessing the read and write latch sections. In this case, the former section using a shift register will be described below.

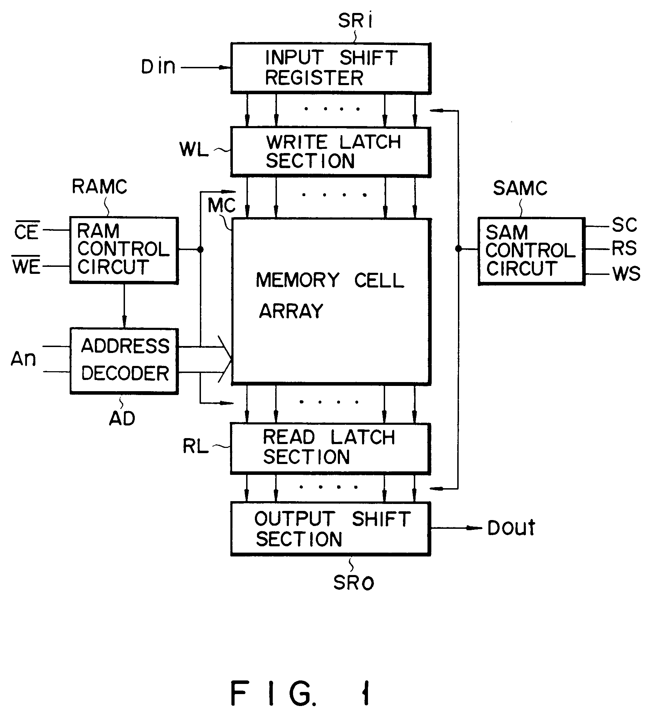

Fig. 1 shows an arrangement of an image memory using shift registers, respectively, in serial input and output sections. Reference symbol SRi denotes an input shift register; WL, a write latch section; MC, a memory cell array; RL, a read latch section; SRo, an output shift register; RAMC, a RAM control circuit; AD, an address decoder; SAMC, a SAM control circuit; C̅E̅, a control signal for the RAM section; W̅E̅, a write/read control signal for the RAM section; Din, write data to be serially input; Dout, readout data to be serially output; SC, a control clock input for the SAM section; and WS, a signal for controlling a data transfer operation from the input shift register SRi to the write latch section WL.

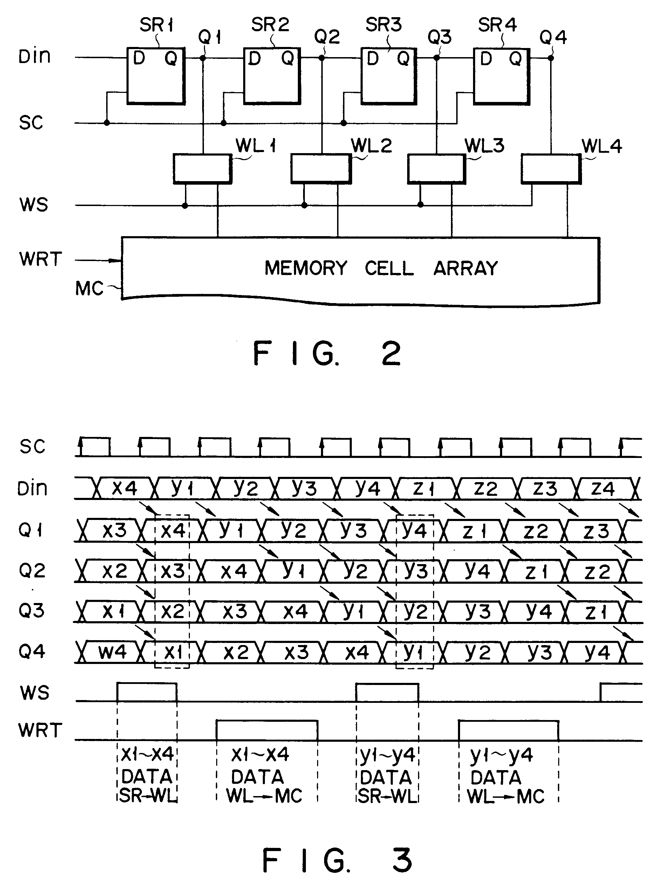

Fig. 2 shows an arrangement of the serial input section constituted by, e.g., four shift registers SR1 to SR4. Fig. 3 is a timing chart of the serial input section shown in Fig. 2. The serial input data Din are sequentially received by the shift registers SR1 to SR4 in response to the clock input SC, and are respectively written in write latches WL1 to WL4 in response to the signal WS every 4-bit input. These data are written by a memory cell array in response to a signal WRT prior to writing of new data in the write latches WL1 to WL4 in response to a next output signal WS. The signal WRT is formed from the control signals C̅E̅ and W̅E̅ for the RAM section. The signal WRT allows a write operation to the memory cell array while being asynchronous with the clock input SC and the signal WS.

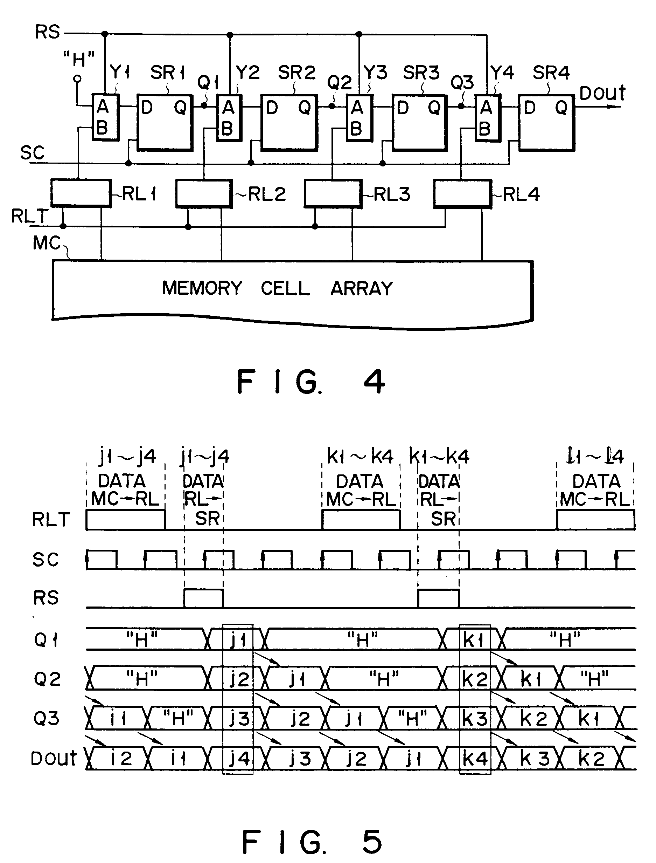

Fig. 4 shows an arrangement of the serial output section constituted by, e.g., four shift registers SR1 to SR4. Fig. 5 is a timing chart of the serial output section shown in Fig. 4. Data in the memory cell array are read out and latched by read latches RL1 to RL4 in response to a signal RLT formed by the control signals C̅E̅ and W̅E̅ for the RAM section. Then, outputs from the read latches RL1 to RL4 are respectively selected by selectors Y1 to Y4 in response to the signal RS, and the selected outputs are sequentially received by the shift registers SR1 to SR4 at a leading edge of the clock input SC. The received outputs are sequentially output from the shift register SR4 as serial output data Dout. In the same manner as in the serial input operation, the signal RLT can read the contents of the memory cells and stores the readout data in the read latches RL1 to RL4 while being asynchronous with the clock input SC before the signal RS is output.

In the image memory shown in Fig. 1, the serial input and output sections may be preferably arranged adjacent to the memory cell array. In this case, a relatively long wiring is required to connect the serial input and output sections to the external clock input SC and the serial input data Din, and the external serial output data Dout. In particular, as shown in Figs. 6 and 7, in the serial output section, if a wiring delay which cannot be neglected occurs in a wiring L between the clock input SC and the serial output data Dout, a serial access time is adversely prolonged. Reference symbol Bi denotes an SC clock input buffer; Bo, a data output buffer; and SR4, a last shift register.

A serial access time required for the image memory is 10 ns to 20 ns. This serial access time must be further shortened when, e.g., a high-quality television receiver with a large screen size which uses an image memory has been developed. A memory capacity tends to increase, and a wiring delay to increase an access time is further increased.

On the other hand, an image memory has a larger capacity and a larger number of high-speed serial ports when e.g., a television receiver which has high quality and a larger screen size and which uses an image memory has been developed. In the image memory shown in Fig. 1, the serial input and output sections may be preferably arranged adjacent to the memory cell array. If the serial input and output sections are arranged adjacent to the memory cell array, the layout of the peripheral sections of the memory cell array becomes difficult, and a chip size and the number of external signal pins are undesirably increased along with the development of a high-capacity and multibit image memory.

More specifically, in order to achieve a high-speed operation, the number of shift registers must be increased because of the restriction of a read/write cycle of the RAM section. The number of shift registers is increased as the number of ports is increased, and the number of bits is also increased when the RAM section has a larger capacity. Therefore, in, e.g., a 4-bit image memory having independent 3-serial I/O ports requires 24 shift registers. In this case, a large number of external signal pins are required to perform control and input/output operations of the serial section, except for the external signal pins required for the RAM section.

When a multibit, high-speed serial port is developed, an external load of the semiconductor integrated circuit must be charged or discharged in a great amount. As a result, a charge/discharge current is increased, and a variation (to be referred to as output noise hereinafter) in power source or ground potential is increased. In a serial access memory, a high-impedance period of an output does not exist, and data are continuously output. Therefore, a voltage amplitude of an output and its time change dV/dt are large as compared with those in a conventional random access memory.

Therefore, output noise is further increased, and operations of the circuits in the memory may be adversely affected.

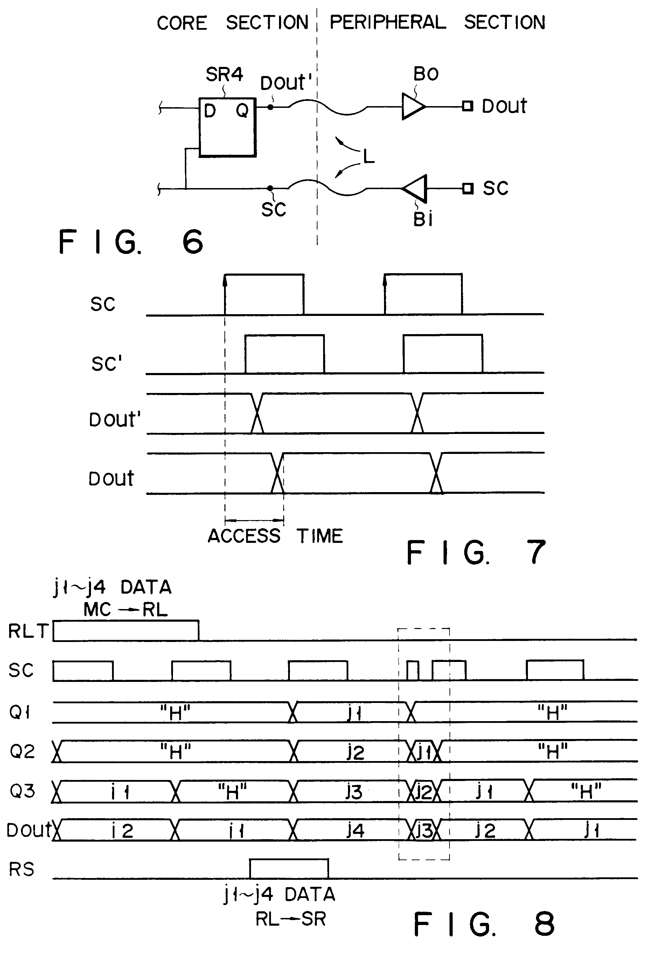

Fig. 8 shows an arrangement of an operation when the potential of the clock input SC is changed due to output noise in the circuit in the serial output section shown in Fig. 4. More specifically, when the clock input SC goes to level "H" from level "L", the output Dout is switched, and the external load is charged or discharged at this time. Therefore, the ground potential of the integrated circuit varies. Therefore, in the integrated circuit, the potential of the clock input SC seems to be changed at a timing when the output Dout is switched, as shown in Fig. 8. In addition, when the output Dout goes to level "H" from level "L", i.e., when the electric charges in the external load are discharged to the ground potential in the integrated circuit, an adverse effect due to the output noise becomes more remarkable.

The registers SR1 to SR4 hold and output data of the immediately preceding cycle when the clock SC is set at level "L". In addition, the registers SR1 to SR4 receive outputs from the selectors Y1 to Y4 through the input terminals thereof, output the data which is received when the clock SC is set at level "H", and invalidate the data input to the input terminals.

At a trailing edge of the output Dout, electric charges are discharged from the external load capacitor to ground, and hence the ground potential of the semiconductor memory is temporarily increased. At this time, all the potentials in the semiconductor memory are determined with reference to the internal ground potential. Therefore, the external clock input SC seems to be "L" at this moment (a part surrounded by a broken line in Fig. 8). Therefore, the shift registers SR1 to SR4 receive new data during a period of time when input data is to be invalidated, and an output is switched. In other words, a data transfer error undesirably occurs.

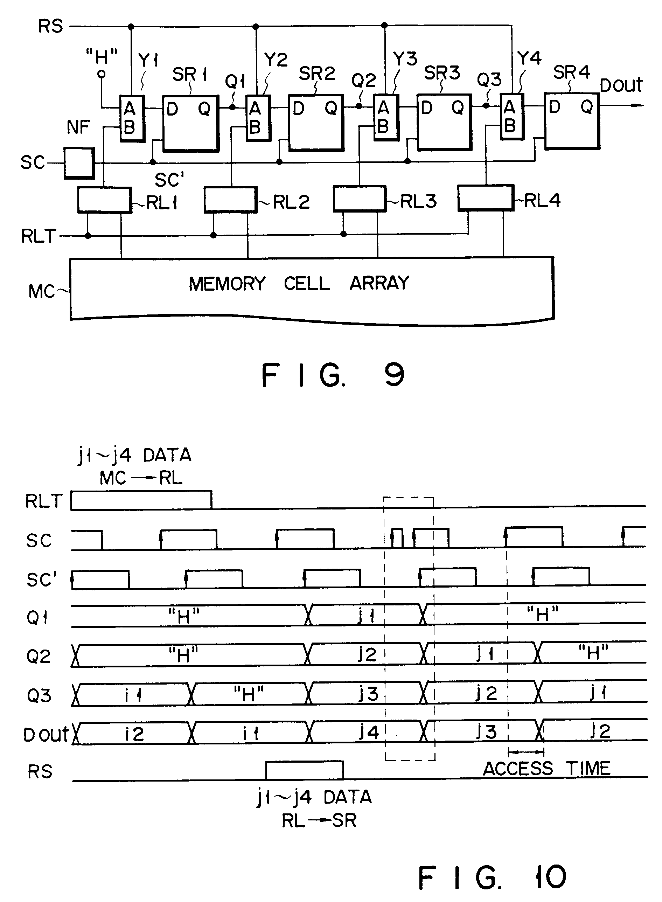

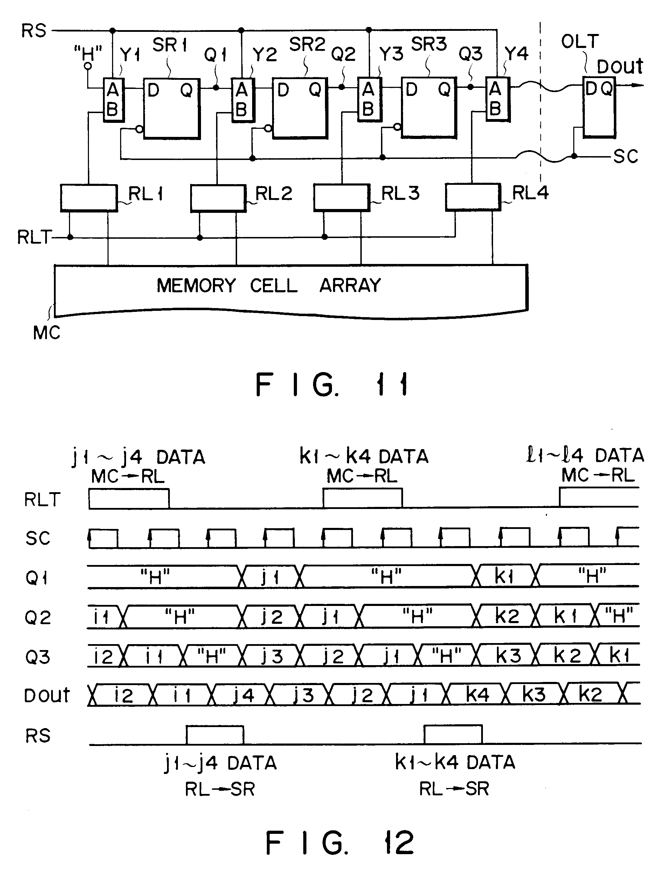

Fig. 9 shows a circuit in which a noise filter NF is inserted in a supply path of the clock input SC, as an arrangement to suppress the above-mentioned variation in potential of the clock input SC due to output noise. Operation waveforms obtained when such an arrangement is employed are shown in, e.g., Fig. 10. Even if the potential of the clock input SC varies due to the output noise, a potential variation in clock input SC′ passed through the noise filter NF is suppressed. Therefore, a data transfer error of the shift registers SR1 to SR4 can be prevented.

Since the clock input SC′ is delayed from the clock input SC by a delay time of the noise filter, timings of a data transfer operation of the shift registers SR1 to SR4 are delayed as compared with a case wherein the noise filter NF is not inserted. More specifically, in the circuit shown in Fig. 9, a serial access time (time until the output Dout is switched from a leading edge of the clock input SC) is undesirably delayed as a side effect of prevention of an operation error of the circuit due to output noise.

It is an object of the present invention to provide a semiconductor memory capable of performing high-speed serial access without a direct effect on a serial access time due to a wiring delay caused between a control clock input and serial output data.

It is another object of the present invention to provide a semiconductor memory which allows easy layout of peripheral sections of a memory cell array, and prevents an increase in chip size and the number of external signal pins.

It is still another object of the present invention to provide a semiconductor memory which can prevent an operation error of a serial output port due to output noise without adversely prolonging a data access time.

The object is achieved as indicated in claims 1 and 3. A semiconductor memory according to a first aspect of the present invention having an output port capable of performing serial access, is characterized in that, of shift registers used in the serial output port, a last shift register connected to an output stage is replaced by an output data latch circuit, and the output data latch circuit is controlled in response to a clock signal shifted from a control clock input to the shift register by a half period.

A semiconductor memory according to a second aspect of the present invention is characterized by comprising a read data latch circuit for temporarily holding data read out from a memory cell array in correspondence with the shift register and the output data latch circuit, in the semiconductor memory according to the first aspect.

A semiconductor memory according to a third aspect of the present invention, comprising an input/output port capable of performing serial access, is characterized in that one-serial shift register is commonly used for the input/output ports, a last shift register of the shift resisters which is connected to an output stage is replaced by an output data latch circuit, and the output data latch circuit is controlled in response to a clock signal shifted from a control clock input to the shift register by a half period.

A semiconductor memory according to a fourth aspect of the present invention is characterized in that the serial input data is latched as a read address of the memory cell, and the latched data is used as an internal address, in the semiconductor memory according to the third aspect.

A semiconductor memory according to a fifth aspect of the present invention is characterized in that a noise filter is inserted in a clock input supply path to each 1-bit shift register, and is not inserted in a clock input supply path to the output data latch circuit, in the semiconductor memories according to the first to fourth aspects.

In the semiconductor memory according to the first aspect, data can be transferred from the memory cell to the serial output port shift register prior to outputting of the data by the output data latch circuit by a half period of the control clock, and hence a high-speed serial access operation can be performed without an adverse effect due to a wiring delay caused between the control clock input and the serial output data.

In the semiconductor memory according to the second aspect, when data read out from the memory cell is temporarily held by the read data latch circuit, the serial output section is separated from the memory cell array. The memory cell can be precharged at the same time as a serial output operation is performed, and a cycle time of the serial output can be decreased.

In the semiconductor memories according to the third and fourth aspects, the number of shift registers is halved as compared with a case wherein independent shift registers are respectively used in the input and output ports. Therefore, easy layout of peripheral section of the memory cell array can be achieved and a chip size can be reduced. In addition, an external address can be serially input as an input, and an external address pin is not required. As a result, a package size can be decreased, and a packaging density can be greatly increased.

In the semiconductor memory according to the fifth aspect, since the noise filter is not inserted in the clock input supply path of the output data latch circuit, a data access time is not adversely prolonged. Since the noise filter is inserted in the clock input supply path of the 1-bit shift resister, a variation in potential of the clock due to output noise can be suppressed, thus preventing an operation error of the serial output port.

This invention can be more fully understood from the following detailed description when taken in conjunction with the accompanying drawings, in which:
Fig. 1 is a block diagram of a conventional image memory;
Fig. 2 is a block diagram of a conventional serial input section;
Fig. 3 is a timing chart of the conventional serial input section shown in Fig. 2;
Fig. 4 is a block diagram of a conventional serial output section;
Fig. 5 is a timing chart of the conventional serial output section shown in Fig. 4;
Fig. 6 is a circuit diagram showing a connection state between the conventional serial output section shown in Fig. 4, a clock input buffer, and a data output buffer;
Fig. 7 is a timing chart of the circuit shown in Fig. 6;
Fig. 8 is a timing chart when the conventional serial output section shown in Fig. 4 is erroneously operated;
Fig. 9 is a block diagram when a noise filter is additionally arranged in the conventional serial output section shown in Fig. 4;
Fig. 10 is a timing chart of the circuit shown in Fig. 9;
Fig. 11 is a block diagram of a serial output section of a semiconductor memory according to the present invention;
Fig. 12 is a timing chart of the serial output section shown in Fig. 11;

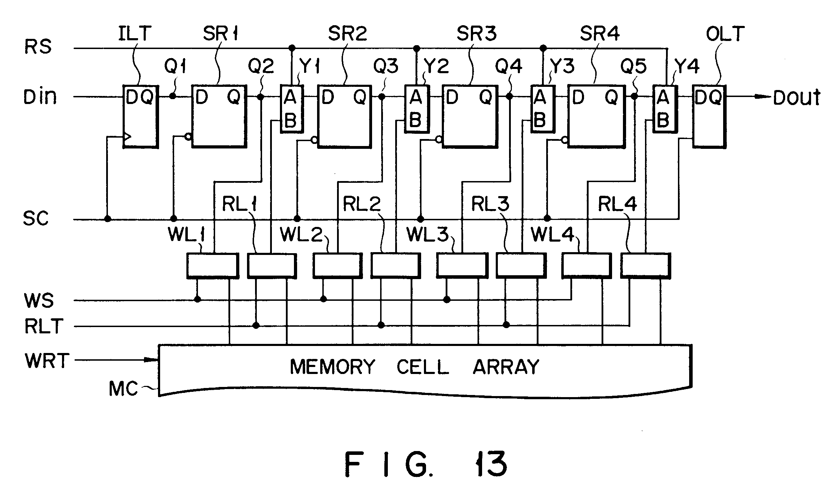

Fig. 13 is a block diagram of a serial input/output section of a semiconductor memory according to the present invention;

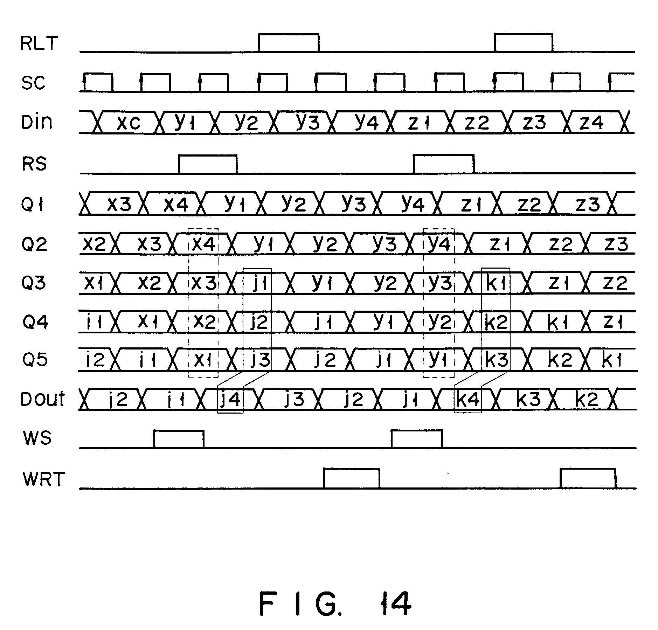

Fig. 14 is a timing chart of the serial input/output section of the semiconductor memory according to the present invention shown in Fig. 13;

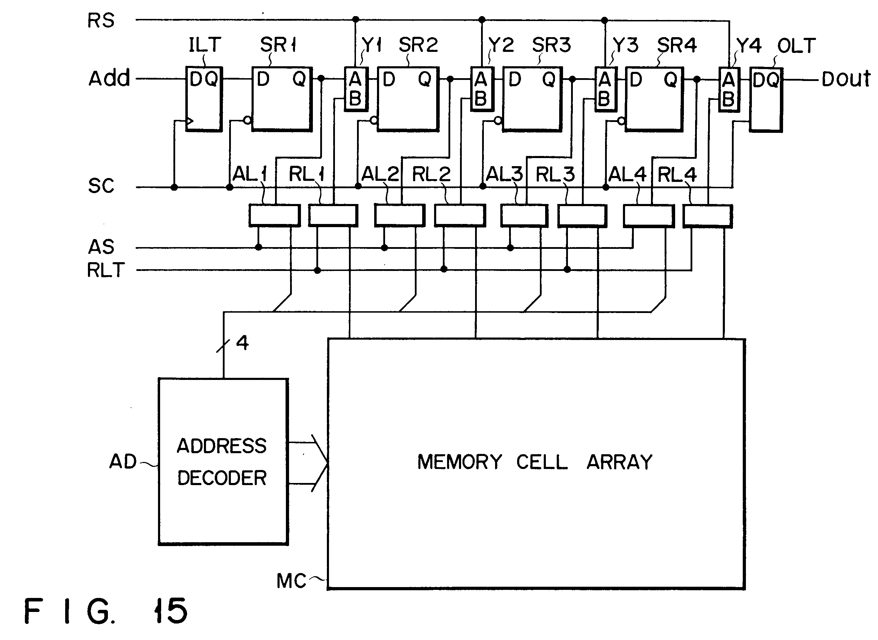

Fig. 15 is a block diagram of the serial input/output section of the semiconductor memory according to the present invention;

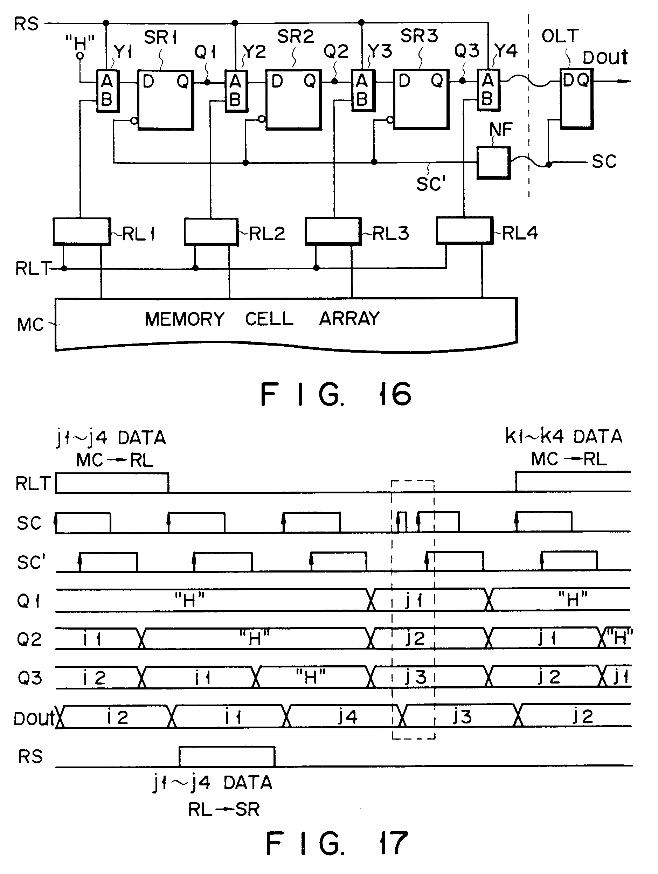

Fig. 16 is a block diagram of a circuit obtained by additionally arranging a noise filter in the serial input/output section of the semiconductor memory according to the present invention shown in Fig. 11;

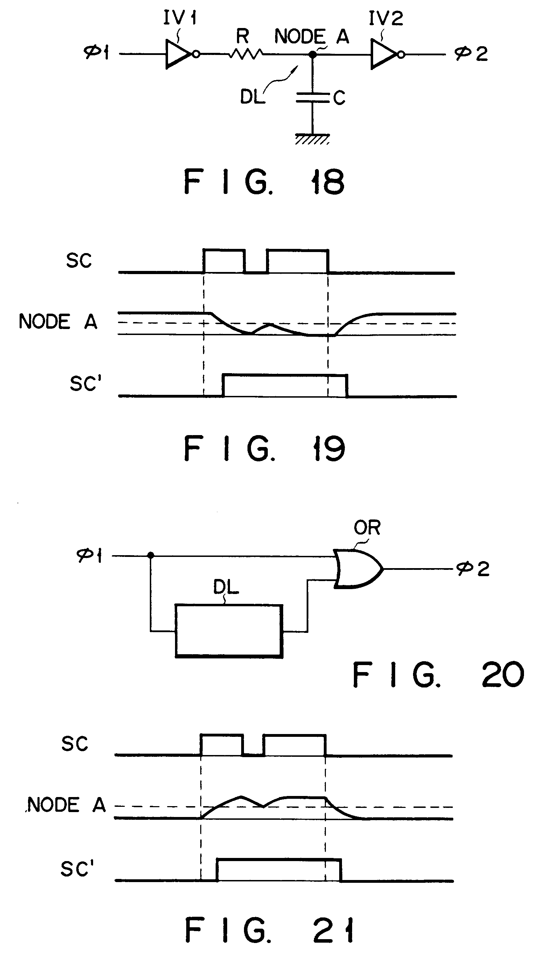

Fig. 17 is a timing chart of the input/output section of the semiconductor memory according to the present invention shown in Fig. 16;
Fig. 18 is a block diagram showing a detailed arrangement of the noise filter shown in Fig. 16;
Fig. 19 is a timing chart of the noise filter shown in Fig. 18;
Fig. 20 is a block diagram showing a detailed arrangement of the noise filter shown in Fig. 16;

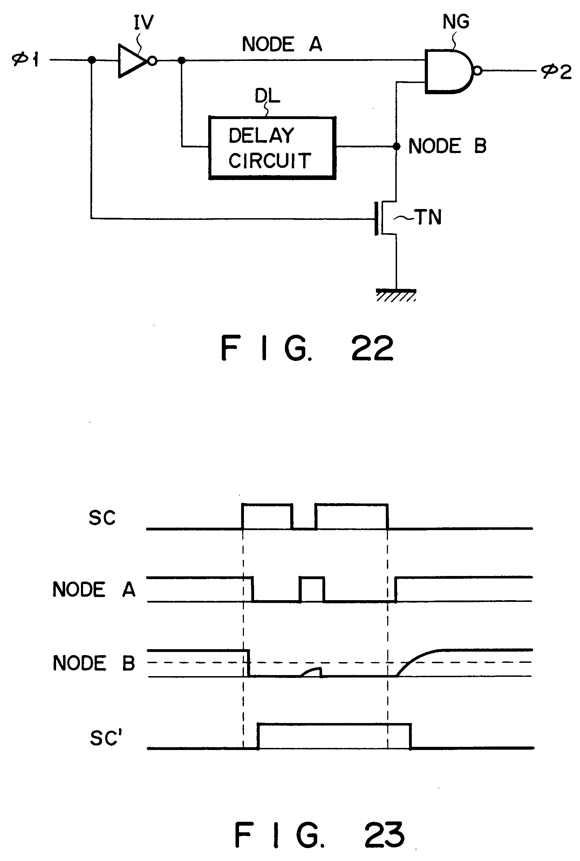

Fig. 21 is a timing chart of the noise filter shown in Fig. 20;
Fig. 22 is a block diagram showing a detailed arrangement of the noise filter shown in Fig. 16; and
Fig. 23 is a timing chart of the noise filter shown in Fig. 22.

An embodiment of the present invention will be described below in detail with reference to the accompanying drawings.

Fig. 11 shows an arrangement of a serial output section in an image memory having an output port capable of performing serial access according to the present invention. In this image memory, the conventional image memory which has been described above with reference to Figs. 1 to 5 is modified as follows. In this image memory, of shift registers used in the serial output port, a last shift register connected to an output stage is replaced by an output data latch circuit, and the output data latch circuit is controlled in response to a clock signal shifted from a control clock for the above-mentioned shift registers by a half period. The remaining arrangement in this image memory is the same as that in the conventional memory.

More specifically, in the serial output section shown in Fig. 11, reference symbols RL1 to RL4 denote read latches for receiving data of a memory cell array when a signal RLT formed by control signals C̅E̅, W̅E̅, and the like for a RAM section is set at "H", and holding the data read out from the memory cell array when the signal RLT is set at "L"; and Y1 to Y4, selectors for selecting an input terminal A/B in accordance with level "H"/"L" of a signal RS. The input terminal B of each of the selectors Y1 to Y4 receives an output (each bit of parallel data) from the corresponding one of the read latches RL1 to RL4. The input terminal A of the selector Y1 is set at "H". Reference symbols SR1 to SR3 denote 1-bit shift registers, and are arranged alternately with the selectors Y1 to Y4.

In this case, each of the 1-bit shift registers SR1 to SR3 receives an output selected by the corresponding one of the first to third selectors Y1 to Y3 through each data input terminal D. An output from each of the registers SR1 to SR3 is input to an input terminal A of the corresponding one of the second to fourth selectors Y2 to Y4. When the clock input SC is set at "L", a data transfer operation is performed (data received from the data input terminal D in an immediately preceding cycle of the clock input SC is output and held, and a data input is received from the data input terminal D). When the clock input SC is set at "H", the data received when the clock input SC is set at "L" is output, and the data input to the data input terminal D is invalidated. These read latches RL1 to RL4, the selectors Y1 to Y4, and the shift registers SR1 to SR3 constitute a parallel-to-serial (P/S) converter. This P/S converter is arranged adjacent to the memory cell array.

In addition, an output data latch circuit OLT is arranged in the peripheral circuit section. The output data latch circuit OLT receives an output selected by the last selector Y4 of the selectors Y1 to Y4 through the data input terminal D, receives and outputs the data supplied to the data input terminal D when the clock input SC is set at "H", and holds the above-mentioned output data and invalidates the data input to the data input terminal D when the clock input SC is set at "L".

Fig. 12 is a timing chart of the serial output section in the image memory according to the present invention shown in Fig. 11. In this serial output section, data can be transferred from the memory cell array to the serial output port shift registers SR1 to SR3 prior to outputting of the data by the output data latch circuit OLT by a half period of the control clock input SC. Therefore, even if the P/S converter section is arranged adjacent to the memory cell array, and the output data latch circuit OLT is arranged in the peripheral circuit section, high-speed serial access can be performed without a direct effect on a serial access time due to a wiring delay caused between the clock input SC and serial output data Dout. Therefore, an image memory having a sufficient operation margin can be realized. In addition, a chip size need not be increased in a circuit arrangement.

Fig. 13 shows an arrangement of the serial input/output section in the image memory having an input/output port capable of performing serial access according to the present invention. In this image memory, the conventional image memory described above with reference to Figs. 1 to 5 is modified as follows. In this image memory, one-serial shift register is commonly used for the input and output ports, and of the shift registers, the last shift register connected to an output stage is replaced by a data latch circuit. This data latch circuit is controlled in response to a clock signal shifted from the control clock for the above-mentioned shift register by a half period. The remaining arrangement of this image memory is the same as that of the conventional image memory.

More specifically, in the serial input/output section shown in Fig. 13, the selectors Y1 to Y4 select the input terminals A/B in accordance with the level "H"/"L" of the signal RS. Reference symbol ILT denotes an input latch circuit for receiving and outputting a data input Din when the clock input SC is set at "H", and holding the above-mentioned output data and invalidating the data input Din when the clock input SC is set at "L"; SR1 to SR4, 1-bit shift registers arranged alternately with the selectors Y1 to Y4.

In this case, an output (write data) from the input latch circuit ILT is input to the data input terminal D of the first 1-bit shift register SR1. An output selected by each of the first to third selectors Y1 to Y3 is input to the data input terminal D of the corresponding one of the second to fourth 1-bit shift registers SR2 to SR4. An output from each of the 1-bit shift registers SR1 to SR4 is input to the data input terminals A of the corresponding one of the first fourth selectors Y1 to Y4. When the clock input SC is set at "L", the input latch circuit ILT holds and outputs the data received from the data input terminal D in an immediately preceding cycle of the clock input SC, and receives the data input to the data input terminal D. When the clock input SC is set at "H", the input latch circuit ILT outputs the data received when the clock input SC is set at "L", and invalidates the data input to the data input terminal D.

Four read data latch circuits RL1 to RL4 corresponding to the four selectors Y1 to Y4 receive bits (data read out from the memory cell array) of parallel data through the data input terminals, respectively. Outputs from the read data latch circuits RL1 to RL4 are input to the data input terminals B of the selectors Y1 to Y4, respectively. Each of the read data latch circuits RL1 to RL4 outputs the data read out from the memory cell array which is supplied to the corresponding data input terminal when the read control signal RLT formed by the control signals C̅E̅, W̅E̅, and the like for the RAM section is set at "H", and holds the output data and invalidates the data input to the corresponding data input terminal when the read control signal RLT is set at "L".

Four write data latch circuits WL1 to WL4 corresponding to the four 1-bit shift registers SR1 to SR4 receive outputs from the 1-bit shift registers SR1 to SR4 through the data input terminals, respectively. Each of the four write data latch circuits WL1 to WL4 outputs data supplied to the corresponding data input terminal when the write control signal WS is set at "H", and holds the output data and invalidates the data input to the corresponding data input terminal when the write control signal WS is set at "L".

These read data latch circuits RL1 to RL4, the write data latch circuits WL1 to WL4, the selectors Y1 to Y4, the input latch circuit ILT, and the shift registers SR1 to SR4 constitute a parallel-to-serial (P/S) converter. This P/S converter is arranged adjacent to the memory cell array.

In addition, the output data latch circuit OLT is arranged in the peripheral circuit section. The output data latch circuit OLT receives an output selected by the last selector Y4 of the selectors Y1 to Y4 through the data input terminal D, receives and outputs the data supplied to the data input terminal D when the clock input SC is set at "H", and holds the above-mentioned output data and invalidates the data input to the data input terminal D when the clock input SC is set at "L".

Fig. 14 is a timing chart of the serial input/output section in the image memory according to the present invention shown in Fig. 13. In this serial input/output section, external inputs can be continuously input to write the inputs in the memory cell array. At the same time, data read out from the memory cell array can be externally and continuously output. In this case, when the data read out from the read data latch circuits RL1 to RL4 are directly supplied to the first to fourth shift registers SR1 to SR4, contention between a write operation of the input data to the write data latch circuits WL1 to WL4 and a read operation of the output data to the shift registers SR1 to SR4 can be prevented.

Since data is transferred from the memory cell array to the serial input/output port shift registers SR1 to SR4 prior to outputting of the data from the data latch circuit OLT by a half period of the control clock input SC, a transient data output error upon switching of the selector can be prevented. In addition, even if the P/S converter section is arranged adjacent to the memory cell array, and the output data latch circuit OLT is arranged in the peripheral circuit section, high-speed serial access can be performed without a direct effect on a serial access time due to a wiring delay caused between the SC clock input and the serial output data Dout.

In the above-mentioned serial input/output section, the number of shift registers used in the input/output port is halved as compared with a case wherein independent shift registers are respectively used for the input and output ports. Therefore, easy layout of peripheral sections of the memory cell array can be achieved, and a chip size can be decreased.

More specifically, in the serial input/output section shown in Fig. 13, even if the serial input/output section is arranged adjacent to the memory cell array, easy layout of peripheral sections of the memory cell array can be achieved, and increases in chip size and the number of external signal pins can be prevented. Therefore, a multibit image memory having a larger capacity and a large number of high-speed ports can be realized.

Fig. 15 shows a modification of the memory shown in Fig. 13. In Fig. 15, the memory shown in Fig. 13 is modified as follows. In the memory shown in Fig. 15, a memory cell read address Add is serially input in place of the write data input Din to the input latch circuit ILT in Fig. 13. In this memory, four address data latch circuits AL1 to AL4 are arranged in place of the four write data latch circuits WL1 to WL4. The address data latch circuits AL1 to AL4 receive outputs from the 1-bit shift registers SR1 to SR4 through the data input terminals, respectively, output data supplied to the data input terminals when an address latch control signal AS is set at "H", and hold the output data and invalidate the data input when the address latch control signal AS is set at "L". The outputs from the four address data latch circuits AL1 to AL4 are input to an address decoder AD as an internal address.

Thus, since the external address ADD can be serially input as an input, the external address pin is not required. Therefore, a package size can be decreased, and a packing density can be greatly increased.

Fig. 16 shows a case wherein a noise filter NF is additionally arranged in the serial output section shown in Fig. 11. The noise filter NF is inserted in only a clock input supply path to the shift registers SR1 to SR3, and is not inserted in a clock input supply path to the output data latch circuit OLT.

In the arrangement shown in Fig. 16, as described above, electric charges flow into ground in the semiconductor memory from the external load capacitor when the serial data output Dout falls. Therefore, the potential of the clock SC is temporarily decreased. When the serial data output Dout rises, electric charges flow toward the external load capacitor from a power source in the semiconductor memory. Therefore, the power source potential is temporarily decreased. At this time, a ground potential is also decreased due to a parasitic capacitance between the internal power source and ground, and the external input SC seems to be temporarily increased. However, an influence of output noise is more remarkable when the serial data output Dout falls to an extent caused by the absence of the parasitic capacitance.

Fig. 17 is a timing chart of the serial output section shown in Fig. 16. More specifically, in the serial output section, even if the potential of the control clock input SC varies due to output noise, a variation in potential of a clock input SC′ which passed through the noise filter NF is suppressed.

The shift registers SR1 to SR3 transfer data bit by bit in response to a trailing edge of the clock input SC′. The output data latch circuit OLT receives and outputs an output from the selector Y4 in response to a leading edge of the clock input SC. As shown in a part surrounded by a broken line in Fig. 17, the output data latch circuit OLT tends to receive input data from the data input terminal in response to "L" of the clock input SC when the potential of the clock input SC varies due to output noise. However, the potential of the clock input SC′ does not vary at the same timing, and the shift registers SR1 to SR3 do not transfer data. Therefore, an output from the selector Y4 is not changed, and the output data latch circuit OLT receives the same data again. As a result, the serial data output Dout is not changed.

In the serial output section shown in Fig. 16, a serial data access time is not increased, thus preventing an operation error of the serial output port due to output noise.

Note that the noise filter NF is arranged, as shown in, e.g., Fig. 18, 20, or 22.

In a noise filter NF shown in Fig. 18, an integrating circuit (delay circuit) DL constituted by a resistor R and a capacitor C is inserted between a first inverter IV1 and a second inverter IV2. Fig. 19 is a timing chart of the noise filter NF. If output noise to temporarily set the clock input SC at "L" from "H" is generated, the potential of an output node of the first inverter IV1 does not perfectly rise, thus suppressing generation of output noise of the clock input SC′. A timing when the clock input SC′ is output is delayed as compared with a timing when the clock input SC is output. However, as described above, the operation of the shift register is shifted from that of the output data latch circuit by a half period of the clock input, and hence a serial data access time is not adversely affected.

A noise filter NF in Fig. 20 includes a 2-input OR gate OR for receiving the clock input SC as one input, and a delay circuit DL for delaying the clock input SC by a predetermined period of time to cause the delayed clock input SC to serve as the other input to the 2-input OR gate OR. Fig. 21 is a timing chart of this noise filter NF. Even if output noise to temporarily change the level of the clock input SC from "H" to "L" is generated, generation of output noise due to the clock input SC′ can be suppressed only when a delay time of the delay circuit DL is set longer than a pulse width of the output noise.

A noise filter NF in Fig. 22 includes an inverter IV for inverting the clock input SC, a 2-input NAND gate NG for receiving an output from the inverter IV as one input, a delay circuit DL for delaying the clock input SC by a predetermined period of time to cause the delayed clock input SC to serve as the other input to the 2-input NAND gate NG, and an n-type MOS transistor TN connected between the output terminal of the delay circuit DL and a ground potential terminal. The transistor TN has a gate for receiving the clock input SC. Fig. 23 is a timing chart of the noise filter NF. Even if output noise to temporarily change the level the clock input SC from "H" to "L" is generated, generation of noise at the output terminal of the delay circuit DL can be suppressed only when a delay time of the delay circuit DL is set longer than a pulse width of the output noise. Therefore, generation of noise due to the clock input SC′ can be suppressed.

In addition, the serial input/output section shown in Fig. 13 may be arranged as follows. The noise filters NF is inserted in the SC clock input supply paths to the input latch circuit ILT and to the 1-bit shift registers SR1 to SR4, respectively, and is not inserted in the SC clock input supply path to the output data latch circuit OLT having a data input terminal for receiving the output selected by the last selector Y4. Therefore, a variation in potential of the clock input SC due to output noise can be suppressed without adversely affecting a serial data access time, as in the above arrangement. Therefore, an operation error of the serial output port can be prevented.

## Claims

1. A semiconductor memory comprising:
n selectors (Y1, Y2, ..., Yn), each having a plurality of data input terminals (A, B, ...), each selector selecting one of said plurality of data input terminals (A, B, ...) in accordance with a state of a selection control signal supplied to said selectors;
(n-1) one-bit shift registers (SR1, SR2, ..., SRn-1), each having a clock signal input terminal and a data signal input terminal, said one-bit shift registers (SR1, SR2, ..., SRn-1) being alternately arranged with said n selectors (Y1, Y2, ..., Yn), said (n-1) one-bit shift registers (SR1, SR2, ..., SRn-1) being arranged such that a given one of said (n-1) one-bit shift registers (SR1, SR2, ..., SRn-1) receives the output from a selector connected to said data signal input terminal of said given one-bit shift register and supplies an output to a first one (A) of said data input terminals of a selector connected to the output terminal of said given one-bit shift register, and said (n-1) one-bit shift registers (SR1, SR2, ..., SRn-1) each being arranged to hold and output data received from said data signal input terminal in an immediately preceding clock input cycle and transfer the data input from said data signal input terminal to said first data input terminal (A) when the clock input is set at a first state, and to hold and output the data received from said data signal input terminal and invalidate the data input to said data signal input terminal in a second state of the clock input; and
characterized by an output data latch circuit (OLT), having a clock input and a data input terminal for receiving an output selected by a last selector (Yn) of said n selectors (Y1, Y2, ..., Yn), for transferring the data supplied to said data input terminal when the clock input is set in said second state, and holding and outputting the data supplied to said data input terminal and invalidating the data input to said data input terminal when the clock input is set in said first state.

2. A semiconductor memory according to claim 1, characterized by further comprising n read data latch circuits (RL1, RL2, ..., RLn), each having a read control signal input terminal and a data input terminal, said n read data latch circuits (RL1, RL2, ..., RLn) being arranged in correspondence with said n selectors (Y1, Y2, ..., Yn), said n read data latch circuits being arranged such that said data input terminal receives a bit of parallel data, an output from each of said read data latch circuits is input to a second one (B) of said data input terminals of the corresponding one of said n selectors (Y1, Y2, ..., Yn), and said read data latch circuits each being arranged to output the data supplied to said data input terminal when a read control signal input is set in a first state, and to hold the output data and invalidate the data input to said data input terminal when the read control signal input is set in a second state.

3. A semiconductor memory comprising:
n selectors (Y1, Y2, ..., Yn), each having a plurality of data input terminals (A, B, ...), each selector selecting one of said plurality of data input terminals (A, B, ...) in accordance with a state of a selection control signal supplied to said selectors;
n one-bit shift registers (SR1, SR2, ..., SRn), each having a clock signal input terminal and a data signal input terminal, said one-bit shift registers (SR1, SR2, ..., SRn) being alternately arranged with said n selectors (Y1, Y2, ..., Yn), said n one-bit shift registers (SR1, SR2, ..., SRn) being arranged such that a data input terminal of a first shift register (SR1) receives serially input write data, a given one of the remaining (n-1) one-bit shift registers (SR2, ..., SRn) receives the output from a selector connected to said data signal input terminal of said given one-bit shift register and supplies an output to a first one (A) of said data input terminals of a selector connected to the output terminal of said given one-bit shift register, and said remaining (n-1) one-bit shift registers (SR2, ..., SRn) each being arranged to hold and output data received from said data signal input terminal in an immediately preceding clock input cycle and transfer the data input from said data signal input terminal to said first data input terminal (A) when the clock input is set in a first state and to hold and output the data received from said data signal input terminal and invalidate the data input to said data signal input terminal in a second state of the clock input;
n read data latch circuits (RL1, RL2, ..., RLn), each having a read control signal input terminal and a data signal input terminal, said n read data latch circuits (RL1, RL2, ..., RLn) being arranged in correspondence with said n selectors, said n read data latch circuits being arranged such that said data input terminal receives a bit of parallel data, an output from each of said read data latch circuits is input to a second one (B) of said data input terminals of the corresponding one of said n selectors, and said read data latch circuits each being arranged to output the data supplied to said data input terminal when a read control signal input is set in a first state, and to hold the output data and invalidate the data input to said data input terminal when the read control signal input is set in a second state; and
n write data latch circuits (WL1, WL2, ..., WLn), each having a write control signal input terminal and a data signal input terminal, said n write data latch circuits (WL1, WL2, ..., WLn) being arranged in correspondence with said n one-bit shift registers (SR1, SR2, ..., SRn), said write data latch circuits being arranged such that said data input terminal receives the output from the corresponding one of said n one-bit shift registers (SR1, SR2, ..., SRn), and said write data latch circuits each being arranged to output the data supplied to said data input terminal when a write control signal input is set in a first state, and to hold the output data and invalidate the data input at said data input terminal when the write control signal input is set in a second state; characterized by
an output data latch circuit (OLT), having a clock input and a data input terminal, said data input terminal receiving an output selected by a last selector (Yn) of said n selectors (Y1, Y2, ..., Yn), said output data latch circuit (OLT) transferring the data supplied to said data input terminal when the clock input is set in said second state, and holding and outputting the data supplied to said data input terminal and invalidating the data input to said data input terminal when the clock input is set in said first state.

4. A semiconductor memory according to claim 3, characterized by further comprising an address decoder (AD) for receiving outputs from said n write data latch circuits (WL1, WL2, ..., WLn).

5. A semiconductor memory according to claim 3, characterized in that a noise filter (NF) is inserted in a clock input supply path to said n one-bit shift registers (SR1, SR2, ..., SRn), and said noise filter (NF) is not inserted in a clock input supply path to said output data latch circuit (OLT).

6. A semiconductor memory according to claim 2, characterized in that a noise filter is inserted in a clock input supply path to said n one-bit shift registers, and said noise filter is not inserted in a clock input supply path to said output data latch circuit.

7. A semiconductor memory according to claim 4, characterized in that a noise filter is inserted in a clock input supply path to said n one-bit shift registers, and said noise filter is not inserted in a clock input supply path to said output data latch circuit.

## Patentansprüche

1. Halbleiterspeicher, welcher folgendes umfaßt:
n Selektoren (Y1, Y2, ..., Yn), von denen jeder über eine Vielzahl von Dateneingangsanschlüssen (A, B, ...) verfügt, wobei jeder Selektor in Übereinstimmung mit dem Zustand eines an den Selektor gelieferten Auswahlsteuersignal aus der Vielzahl von Dateneingangsanschlüssen (A, B, ...) einen auswählt;
(n-1) 1-Bit-Schieberegister (SR1, SR2, ..., SRn-1) mit jeweils einem Taktsignaleingangsanschluß und einem Datensignaleingangsanschluß, wobei die 1-Bit-Schieberegister (SR1, SR2, ..., SRn-1) abwechselnd mit den n Selektoren (Y1, Y2, ..., Yn) so angeordnet sind, daß die (n-1) 1-Bit-Schieberegister (SR1, SR2, ..., SRn-1) so aufgebaut sind, daß ein gegebenes der (n-1) 1-Bit-Schieberegister (SR1, SR2, ..., SRn-1) den Ausgang eines mit dem Ausgangsanschluß des gegebenen 1-Bit-Schieberegisters gekoppelten Selektors empfängt und einen Ausgang an einen ersten (A) der Dateneingangsanschlüsse eines mit dem Ausgangsanschluß des gegebenen 1-Bit-Schieberegisters gekoppelten Selektors liefert, und wobei die (n-1) 1-Bit-Schieberegister (SR1, SR2, ..., SRn-1) jeweils so aufgebaut sind, daß sie die vom Datensignaleingangsanschluß in dem unmittelbar vorhergehenden Takteingangszyklus empfangenen Daten halten und ausgeben und die Daten vom Datensignaleingangsanschluß an den ersten Dateneingangsanschluß (A) übertragen, wenn der Takteingang auf einen ersten Zustand gesetzt ist, und die vom Datensignaleingangsanschluß erhaltenen Daten halten und ausgeben sowie den Dateneingang zum Datensignaleingangsanschluß in einem zweiten Zustand des Takteingangs ungültig machen bzw. sperren;
und gekennzeichnet durch eine Ausgangsdaten-Zwischenspeicherschaltung (OLT) mit einem Takteingangs- und einem Dateneingangsanschluß zum Empfang eines Ausgangs eines letzten Selektors (Yn) der n Selektoren (Y1, Y2, ..., Yn), zur Übertragung der an den Dateneingangsanschluß gelieferten Daten, wenn der Takteingang in den zweiten Zustand gesetzt ist, zum Halten und zur Ausgabe der an den ersten Dateneingangsanschluß gelieferten Daten und zum Sperren des Dateneingangs am Dateneingangsanschluß, wenn der Takteingang in den zweiten Zustand gesetzt ist.

2. Halbleiterspeicher gemäß Anspruch 1, dadurch gekennzeichnet, daß er des weiteren n Lesedaten-Zwischenspeicherschaltungen (RL1, RL2, ..., RLn) umfaßt, von denen jede über einen Lesesteuersignaleingangsanschluß und einen Dateneingangsanschluß verfügt, wobei die n Lesedaten-Zwischenspeicherschaltungen (RL1, RL2, ..., RLn) in Übereinstimmung mit den n Selektoren (Y1, Y2, ..., Yn) angeordnet und die n Lesedaten-Zwischenspeicherschaltungen so aufgebaut sind, daß der Dateneingangsanschluß ein Bit der parallelen Daten empfängt, ein Ausgang jeder der Lesedaten-Zwischenspeicherschaltungen in einen zweiten (B) der Dateneingangsanschlüsse des entsprechenden der n Selektoren (Y1, Y2, ..., Yn) eingegeben wird, und die Lesedaten-Zwischenspeicherschaltungen jeweils so aufgebaut sind, daß sie das an den Dateneingangsanschluß gelieferte Datum ausgeben, wenn ein Lesesteuersignaleingang in einen ersten Zustand gesetzt ist, und das Ausgangsdatum halten und den Dateneingang zum Dateneingangsanschluß sperren, wenn der Lesesteuersignaleingang in einen zweiten Zustand gesetzt ist.

3. Halbleiterspeicher, welcher folgendes umfaßt:
n Selektoren (Y1, Y2, ..., Yn), von denen jeder über eine Vielzahl von Dateneingangsanschlüssen (A, B, ...) verfügt, wobei jeder Selektor in Übereinstimmung mit dem Zustand eines an den Selektor gelieferten Auswahlsteuersignal aus der Vielzahl von Dateneingangsanschlüssen (A, B, ...) einen auswählt;
n 1-Bit-Schieberegister (SR1, SR2, ..., SRn) mit jeweils einem Taktsignaleingangsanschluß und einem Datensignaleingangsanschluß, wobei die 1-Bit-Schieberegister (SR1, SR2, ..., SRn) abwechselnd mit den n Selektoren (Y1, Y2, ..., Yn) so angeordnet sind, daß die n 1-Bit-Schieberegister (SR1, SR2, ..., SRn) so aufgebaut sind, daß ein Dateneingang eines ersten Schieberegisters (SR1) seriell eingegebene Eingangsschreibdaten empfängt, ein gegebenes der übrigen (n-1) 1-Bit-Schieberegister (SR2, ..., SRn) den Ausgang eines mit dem Datensignaleingangsanschluß des gegebenen 1-Bit-Schieberegisters gekoppelten Selektors empfängt und einen Ausgang an einen ersten (A) der Dateneingangsanschlüsse eines mit dem Ausgangsanschluß des gegebenen 1-Bit-Schieberegisters gekoppelten Selektors liefert, und wobei die übrigen (n-1) 1-Bit-Schieberegister (SR2, ..., SRn) jeweils so aufgebaut sind, daß sie die vom Datensignaleingangsanschluß in dem unmittelbar vorhergehenden Takteingangszyklus empfangenen Daten halten und ausgeben und die Daten vom Datensignaleingangsanschluß an den ersten Dateneingangsanschluß (A) übertragen, wenn der Takteingang auf einen ersten Zustand gesetzt ist, und die vom Datensignaleingangsanschluß erhaltenen Daten halten und ausgeben sowie den Dateneingang zum Datensignaleingangsanschluß in einem zweiten Zustand des Takteingangs ungültig machen bzw. sperren;
n Lesedaten-Zwischenspeicherschaltungen (RL1, RL2, ..., RLn), von denen jede über einen Lesesteuersignaleingangsanschluß und einen Dateneingangsanschluß verfügt, wobei die n Lesedaten-Zwischenspeicherschaltungen (RL1, RL2, ..., RLn) in Übereinstimmung mit den n Selektoren angeordnet und die n Lesedaten-Zwischenspeicherschaltungen so aufgebaut sind, daß der Dateneingangsanschluß ein Bit der parallelen Daten empfängt, ein Ausgang jeder der Lesedaten-Zwischenspeicherschaltungen in einen zweiten (B) der Dateneingangsanschlüsse des entsprechenden der n Selektoren eingegeben wird, und die Lesedaten-Zwischenspeicherschaltungen jeweils so aufgebaut sind, daß sie das an den Dateneingangsanschluß gelieferte Datum ausgeben, wenn ein Lesesteuersignaleingang in einen ersten Zustand gesetzt ist, und das Ausgangsdatum halten und den Dateneingang zum Dateneingangsanschluß sperren, wenn der Lesesteuersignaleingang in einen zweiten Zustand gesetzt ist; und
n Schreibdaten-Zischenspeicherschaltungen (WL1, WL2, ..., WLn), von denen jede über einen Schreibsteuersignaleingangsanschluß und einen Dateneingangsanschluß verfügt, wobei die n Schreibdaten-Zwischenspeicherschaltungen (WL1, WL2, ..., WLn) in Übereinstimmung mit den n 1-Bit-Schieberegistern (SR1, SR2, ..., SRn) angeordnet und die Schreibdaten-Zwischenspeicherschaltungen so aufgebaut sind, daß der Dateneingangsanschluß den Ausgang des entsprechenden der n 1-Bit-Schieberegister (SR1, SR2, ..., SRn) empfängt, und die Schreibdaten-Zwischenspeicherschaltungen jeweils so aufgebaut sind, daß sie das an den Dateneingangsanschluß gelieferte Datum ausgeben, wenn ein Schreibsteuersignaleingang in einen ersten Zustand gesetzt ist, und das Ausgangsdatum halten und den Dateneingang zum Dateneingangsanschluß sperren, wenn der Schreibsteuersignaleingang in einen zweiten Zustand gesetzt ist;
gekennzeichnet durch eine Ausgangsdaten-Zwischenspeicherschaltung (OLT) mit einem Takteingangs- und einem Dateneingangsanschluß, wobei der Dateneingangsanschluß einen Ausgang eines letzten Selektors (Yn) der n Selektoren (Y1, Y2, ..., Yn) empfängt, die Ausgangsdaten-Zwischenspeicherschaltung (OLT) die an den Dateneingangsanschluß gelieferten Daten, wenn der Takteingang in den zweiten Zustand gesetzt ist, überträgt und die an den Dateneingangsanschluß gelieferten Daten hält und ausgibt sowie den Dateneingang zum Dateneingangsanschluß sperrt, wenn der Takteingang in den zweiten Zustand gesetzt ist.

4. Halbleiterspeicher gemäß Anspruch 3, dadurch gekennzeichnet, daß er des weiteren einen Adressendecoder (AD) zum Empfang der Ausgänge der n Schreibdaten-Zwischenspeicherschaltungen (WL1, WL2, ..., WLn) umfaßt.

5. Halbleiterspeicher gemäß Anspruch 3, dadurch gekennzeichnet, daß ein Rauschfilter (NF) in einen Takteingangszuführpfad zu den n 1-Bit-Schieberegistern (SR1, SR2, ..., SRn) eingeschaltet ist, und das Rauschfilter (NF) nicht in einen Takteingangszuführpfad zu der Ausgangsdaten-Zwischenspeicherschaltung (OLT) eingeschaltet ist.

6. Halbleiterspeicher gemäß Anspruch 2, dadurch gekennzeichnet, daß das Rauschfilter in einen Takteingangszuführpfad zu den n 1-Bit-Schieberegistern eingeschaltet ist, und das Rauschfilter nicht in einen Takteingangszuführpfad zu der Ausgangsdaten-Zwischenspeicherschaltung eingeschaltet ist.

7. Halbleiterspeicher gemäß Anspruch 4, dadurch gekennzeichnet, daß ein Rauschfilter in einen Takteingangszuführpfad zu den n 1-Bit-Schieberegistern eingeschaltet ist, und das Rauschfilter nicht in einen Takteingangszuführpfad zu der Ausgangsdaten-Zwischenspeicherschaltung eingeschaltet ist.

## Revendications

1. Mémoire à semiconducteur comprenant :
n sélecteurs (Y1, Y2, ..., Yn) dont chacun comporte une pluralité de bornes d'entrée de données (A, B, ...), chaque sélecteur sélectionnant l'une de ladite pluralité de bornes d'entrée de données (A, B, ...) conformément à un état d'un signal de commande de sélection appliqué auxdits sélecteurs ;
(n-1) registres à décalage d'un bit (SR1, SR2, ..., SRn-1) dont chacun comporte une borne d'entrée de signal d'horloge et une borne d'entrée de signal de donnée, lesdits registres à décalage d'un bit (SR1, SR2, ..., SRn-1) étant agencés en alternance avec lesdits n sélecteurs (Y1, Y2, ..., Yn), lesdites (n-1) registres à décalage d'un bit (SR1, SR2, ..., SRn-1) étant agencés de telle sorte que l'un donne desdits (n-1) registres à décalage d'un bit (SR1, SR2, ..., SRn-1) reçoive la sortie en provenance d'un sélecteur commuté à ladite borne d'entrée de signal de donnée dudit registre à décalage d'un bit donné et applique une sortie sur une première (A) desdites bornes d'entrée de données d'un sélecteur connecté à la borne de sortie dudit registre à décalage d'un bit donné, et lesdits (n-1) registres à décalage d'un bit (SR1, SR2, ..., SRn-1), chacun étant agencé pour bloquer et émettre en sortie des données reçues depuis ladite borne d'entrée de signal de donnée lors d'un cycle d'entrée d'horloge immédiatement précédent et pour transférer les données entrées depuis ladite borne d'entrée de signal de données sur ladite première borne d'entrée de données (A) lorsque l'entrée d'horloge est établie dans un premier état et pour bloquer et émettre en sortie les données reçues depuis ladite borne d'entrée de signal de donnée et pour invalider l'entrée de données sur ladite borne d'entrée de signal de donnée dans un second état de l'entrée d'horloge ; et
caractérisée par un circuit de verrouillage de données de sortie (OLT) comportant une entrée d'horloge et une borne d'entrée de données pour recevoir une sortie sélectionnée par un dernier sélecteur (Yn) desdits n sélecteurs (Y1, Y2, ..., Yn), pour transférer des données appliquées sur ladite borne d'entrée de données lorsque l'entrée d'horloge est établie dans ledit second état et pour bloquer et émettre en sortie les données appliquées sur ladite borne d'entrée de données et pour invalider les données entrées sur ladite borne d'entrée de données lorsque l'entrée d'horloge est établie dans ledit premier état.

2. Mémoire à semiconducteur selon la revendication 1, caractérisée en ce qu'elle comprend en outre n circuits de verrouillage de données de lecture (RL1, RL2, ..., RLn), dont chacun comporte une borne d'entrée de signal de commande de lecture et une borne d'entrée de données, lesdits n circuits de verrouillage de données de lecture (RL1, RL2, ..., RLn) étant agencés en correspondance avec lesdits n sélecteurs (Y1, Y2, ..., Yn), lesdits n circuits de verrouillage de données de lecture étant agencés de telle sorte que ladite borne d'entrée de données reçoive un bit de données parallèles, une sortie provenant de chacun desdits circuits de verrouillage de données de lecture est entrée sur une seconde (B) desdites bornes d'entrée de données de l'un correspondant desdits n sélecteurs (Y1, Y2, ..., Yn) et lesdits circuits de verrouillage de données de lecture étant chacun agencé pour émettre en sortie les données appliquées sur ladite borne d'entrée de donnée lorsqu'une entrée de signal de commande de lecture est établie dans un premier état et pour bloquer les données de sortie et invalider les données entrées sur ladite borne d'entrée de données lorsque l'entrée de signal de commande de lecture est établie dans un second état.

3. Mémoire à semiconducteur comprenant :
n sélecteurs (Y1, Y2, ..., Yn) dont chacun comporte une pluralité de bornes d'entrée de données (A, B, ...), chaque sélecteur sélectionnant l'une de ladite pluralité de bornes d'entrée de données (A, B, ...) en relation avec un état d'un signal de commande de sélection appliqué sur ledit sélecteur ;
n registres à décalage d'un bit (SR1, SR2, ..., SRn-1) dont chacun comporte une borne d'entrée de signal d'horloge et une borne d'entrée de signal de donnée, lesdits registres à décalage d'un bit (SR1, SR2, ..., SRn-1) étant agencés en alternance avec lesdits n sélecteurs (Y1, Y2, ..., Yn), lesdites n registres à décalage d'un bit (SR1, SR2, ..., SRn-1) étant agencés de telle sorte qu'une bande d'entrée de donnée d'un premier registre à décalage (SR1, SR2, ..., SRn-1) reçoive des données d'écriture entrées série, de telle sorte que l'un donné des (n-1) registres à décalage d'un bit restants (SR1, SR2, ..., SRn-1) reçoive la sortie en provenance d'un sélecteur connecté à ladite borne d'entrée de signal de donnée dudit registre à décalage d'un bit donné et applique une sortie sur une première (A) desdites borne d'entrée de donnée d'un sélecteur connecté à la borne de sortie dudit registre à décalage d'un bit donné, de telle sorte que lesdits (n-1) registres à décalage d'un bit restant (SR2, ..., SRn) dont chacun est agencé pour bloquer et émettre en sortie des données reçues depuis ladite borne d'entrée de signal de donnée lors d'un cycle d'entrée d'horloge immédiatement précédent et pour transférer les données entrées sur ladite borne d'entrée de signal de données jusque sur ladite première borne d'entrée de données (A) lorsque l'entrée d'horloge est établie dans un premier état et pour bloquer et émettre en sortie les données reçues depuis ladite borne d'entrée de signal de donnée et pour invalider l'entrée de données sur ladite borne d'entrée de signal de données dans un second état de l'entrée d'horloge ;
n circuits de verrouillage de données de lecture (RL1, RL2, ..., RLn) dont chacun comporte une borne d'entrée de signal de commande de lecture et une borne d'entrée de signal de données, lesdits n circuits de verrouillage de données de lecture (RL1, RL2, ..., RLn) étant agencés en correspondance avec lesdits n sélecteurs, lesdits n circuits de verrouillage de données de lecture étant agencés de telle sorte que ladite borne d'entrée de donnée reçoive un bit de données parallèles, une sortie en provenance de chacun desdits circuits de verrouillage de données de lecture est entrée sur une dite seconde (B) desdites bornes d'entrée de données de l'un correspondant desdits n sélecteurs et lesdits circuits de verrouillage de données de lecture étant chacun agencé pour émettre en sortie les données appliquées sur ladite borne d'entrée de données lorsqu'un signal de commande de lecture entré est établi dans un premier état et pour bloquer les données de sortie et invalider l'entrée de données sur ladite borne d'entrée de données lorsque l'entrée de signal de commande de lecture est établie dans un second état ; et
n circuits de verrouillage de données d'écriture (WL1, WL2, ..., WLn) dont chacun comporte une borne d'entrée de signal de commande d'écriture et une borne d'entrée de signal de données, lesdits n circuits de verrouillage de données d'écriture (WL1, WL2, ..., WLn) étant agencés en correspondance avec lesdits n registres à décalage d'un bit (SR1, SR2, ..., SRn), lesdits circuits de verrouillage de données d'écriture étant agencés de telle sorte que ladite borne d'entrée de données reçoive la sortie en provenance de l'un correspondant desdits n registres à décalage d'un bit (SR1, SR2, ..., SRn), et lesdits circuits de verrouillage de données d'écriture étant chacun agencés pour émettre en sortie les données appliquées sur ladite borne d'entrée de données lorsqu'une entrée de signal de commande d'écriture est établie dans un premier état et pour bloquer les données de sortie et invalider l'entrée de données au niveau de ladite borne d'entrée de données lorsque l'entrée de signal de commande d'écriture est établie dans un second état,
caractérisée par un circuit de verrouillage de données de sortie (OLT) comportant une entrée d'horloge et une borne d'entrée de données, ladite borne d'entrée de données recevant une sortie sélectionnée par un dernier sélecteur (Yn) desdits n sélecteurs (Y1, Y2, ..., Yn), ledit circuit de verrouillage de données de sortie (OLT) transférant les données appliquées sur ladite borne d'entrée de données lorsque l'entrée d'horloge est établie dans le second état et sur ladite borne d'entrée de données et invalidant l'entrée de données sur ladite borne d'entrée de données lorsque l'entrée d'horloge est établie dans ledit premier état.

4. Mémoire à semiconducteur selon la revendication 3, caractérisée en ce qu'elle comprend en outre un décodeur d'adresse (AD) pour reçoive des sorties en provenance desdits n circuits de verrouillage de données d'écriture (WL1, WL2, ..., WLn).

5. Mémoire à semiconducteur selon la revendication 3, caractérisée en ce qu'un filtre antiparasite (NF) est inséré dans une voie d'application d'entrée d'horloge sur lesdits n registres à décalage d'un bit (SR1, SR2, ..., SRn) et ledit filtre antiparasite (NF) n'est pas inséré dans une voie d'application d'entrée d'horloge sur ledit circuit de verrouillage de données de sortie (OLT).

6. Mémoire à semiconducteur selon la revendication 2, caractérisée en ce qu'un filtre antiparasite est inséré dans une voie d'application d'entrée d'horloge sur lesdits n registres de décalage d'un bit et ledit filtre antiparasite n'est pas inséré dans une bonne application d'entrée d'horloge sur ledit circuit de verrouillage de données de sortie.

7. Mémoire à semiconducteur selon la revendication 4, caractérisée en ce qu'un filtre antiparasite est inséré dans une voie d'application d'entrée d'horloge sur lesdits n registres à décalage d'un bit et ledit filtre antiparasite n'est pas inséré dans une voie d'application d'entrée d'horloge sur ledit circuit de verrouillage de données de sortie.
